# EUROPÄISCHE PATENTSCHRIFT

(11) **EP 2 286 643 B1**
(45) Veröffentlichungstag und Bekanntmachung des Hinweises auf die Patenterteilung: **07.09.2016**
(21) Anmeldenummer: 09741871.9
(22) Anmeldetag: 05.05.2009
(51) Int. Cl.: H05H 1/46, H01J 37/34

(54) **VORRICHTUNG UND VERFAHREN ZUM HOCHLEISTUNGS-PULS-GASFLUSS-SPUTTERN**
DEVICE AND METHOD FOR HIGH-PERFORMANCE PULSED GAS FLOW SPUTTERING
DISPOSITIF ET PROCÉDÉ DE PULVÉRISATION CATHODIQUE À FLUX GAZEUX PAR IMPULSIONS HAUTE PUISSANCE

(30) Priorität: 05.05.2008 DE 102008022145
(43) Veröffentlichungstag der Anmeldung: 23.02.2011
(73) Patentinhaber: Fraunhofer-Gesellschaft zur Förderung der angewandten Forschung e.V., 80686 München (DE)
(72) Erfinder: BANDORF, Ralf, 31241 Ilsede (DE); JUNG, Thomas, 38173 Sickte (DE); ORTNER, Kai, 38108 Braunschweig (DE)
(74) Vertreter: Pfenning, Meinig & Partner mbB
(86) Internationale Anmeldenummer: PCT/EP2009/003218
(87) Internationale Veröffentlichungsnummer: WO 2009/135652

(56) Entgegenhaltungen:
- DE-A1- 4 235 953
- US-A- 3 851 213
- US-A- 4 963 239
- US-A1- 2005 029 088
- DELAHOY A E ET AL: "Reactive-environment, hollow cathode sputtering: basic characteristics and application to Al2O3, doped ZnO, and In2O3:Mo" JOURNAL OF VACUUM SCIENCE & TECHNOLOGY A (VACUUM, SURFACES, AND FILMS) AIP FOR AMERICAN VACUUM SOC USA, Bd. 22, Nr. 4, Juli 2004 (2004-07), Seiten 1697-1704, XP002538590 ISSN: 0734-2101

## Beschreibung

Die vorliegende Erfindung betrifft eine Gasflußsputter-Quelle mit einer Hohlkathode zum Beschichten von Substraten sowie ein Verfahren zur Beschichtung von Substraten mittels gepulstem Gasflußsputtern.

Gasflußsputter-Quellen sind in der Technik allgemein bekannt. In der Regel weisen Gasflußsputter-Quellen eine Hohlkathode, auf deren einer Seite eine Einströmvorrichtung für einen Inertgasstrom und auf deren anderer Seite eine Öffnung, hinter welcher sich ein zu beschichtendes Substrat befindet, angeordnet ist, und eine in gewisser Entfernung angebrachte Anode auf. Dabei dient die Hohlkathode als Target. Die Sputterquelle wird entweder mittels Gleichspannung oder mittels Wechselspannung betrieben. Eine solche Sputterquelle wird in der DD 294 511 A5 offenbart, wobei mehrere elektrisch voneinander isolierte Targets eine Hohlkathode mit quadratischem Querschnitt bilden. Eine weitere Ausführungsform einer Sputterquelle wird in der DE 42 35 953 A1 beschrieben, wobei eine lineare Hohlkathode mit planaren, parallel zueinander angeordneten Elektroden von gleicher oder ähnlicher Größe verwendet wird. Durch die beiden Elektroden und senkrecht dazu angeordnete, nicht leitende Seitenflächen wird ein Hohlraum aufgespannt, innerhalb dessen unter geeigneten Umständen eine Hohlkathoden-Glimmentladung stattfinden kann.

Beim Gasflußsputtern kommt es durch das Zuführen von Inertgas in den Innenraum der Hohlkathode zu einer Hohlkathoden-Glimmentladung des Inertgases und das dadurch abgestäubte Kathodenmaterial gelangt durch die Öffnung auf das Substrat, wo es sich ablagert. Beim reaktiven Gasflußsputtern wird zusätzlich zum Inertgasstrom reaktives Gas zugeführt, so dass vorzugsweise das von den Kathoden abgestäubte Material mit dem Reaktivgas reagiert.

Die durch die Hohlkathodenentladung entstandenen Plasmaionen treffen auf die Kathoden auf und schlagen dabei Targetatome aus den Kathoden heraus. Dabei geben die Plasmaionen ihre Energie ab, wobei jedoch nur ein geringer Teil der Energie in kinetische Energie der Targetatome übergeht. Somit gelangen die Targetatome nur langsam zum Substrat und treffen mit niedrigen Energien auf dieses auf. Es liegen also durch den Prozess der Kathodenabstäubung keine energiereichen Teilchen zur Schichtbildung vor. Dies erweist sich als Nachteil, da für das Abscheiden von Schichten mit besonderer Beschaffenheit, beispielsweise von harten Schichten, eine erhöhte Energie des zerstäubten Targetmaterials notwendig ist. Daher wird herkömmlicherweise zusätzlich eine Biasspannung angelegt. Eine Biasspannung lässt sich jedoch speziell im Fall von isolierenden Schichten oder isolierenden Substraten nur begrenzt oder gar nicht einsetzen. Außerdem kann die Biasspannung nur auf Plasmaionen, nicht aber auf schichtbildende Targetatome wirken.

Ziel der Erfindung ist es daher, eine Gasflußsputter-Quelle und ein Verfahren zur Herstellung von stabilen, dichten und/oder harten Beschichtungen zur Verfügung zu stellen.

Diese Aufgabe wird durch die Gasflußsputter-Quelle nach Anspruch 1 und den vorteilhaften Weiterbildungen in den zugehörigen abhängigen Ansprüchen sowie durch das Verfahren zur Beschichtung von Substraten mittels Gasflußsputtern nach Anspruch 6 und dessen vorteilhaften Ausgestaltungsformen nach den zugehörigen, abhängigen Ansprüchen gelöst.

Die erfindungsgemäße Gasflußsputter-Quelle weist grundsätzlich einen herkömmlichen Aufbau auf, also eine Hohlkathode mit beliebigem Querschnitt, an deren erster Öffnung mindestens eine Einströmvorrichtung für Inertgas angebracht ist und durch deren zweite Öffnung die Targetteilchen aus der Hohlkathode austreten können, um sich auf dem in unmittelbarer Nähe der Öffnung angeordneten Substrat abzulagern. In gewissem Abstand zur Hohlkathode befindet sich eine Anode. Erfindungsgemäß zeichnet sich die Gasflußsputter-Quelle durch den Einsatz speziell gepulster Spannungsquellen, insbesondere zur Erzeugung hoher Spitzenleistungen im Puls und/oder zur Erzeugung einer erhöhten Leistungsdichte auf einer Hohlkathodenoberfläche aus. Als Spannungsquelle bietet sich insbesondere ein Hochleistungspulsgenerator an, mit dem Spannungspulse mit einer hoher gemittelter Leistungsdichte auf der Kathodenoberfläche pro Puls, mit hohen Spitzenleistungen im Puls und mit einem Tastverhältnis (engl. "Duty cycle") von kleiner oder gleich 50 % erzeugbar sind. Unter dem Tastverhältnis versteht man das Verhältnis von der Dauer eines einzelnen Pulses zur Zeitspanne zwischen dem Einsetzen eines ersten Pulses und dem Einsetzen eines zweiten, direkt auf den ersten folgenden Pulses.

Bevorzugt ist die erfindungsgemäße Gasflußsputter-Quelle an einen Hochleistungspulsgenerator angeschlossen, welcher Pulse mit Spitzenleistungen im Puls im Bereich von 100 kW bis 50 MW, insbesondere im Bereich von einigen 100 kW bis einigen MW, insbesondere im Bereich von 200 kW bis 3 MW, erzeugt.

Vorteilhafterweise ist die erfindungsgemäße Gasflußsputter-Quelle an einen Hochleistungspulsgenerator, mit dem eine gepulste Spannung, bevorzugt eine gepulste Gleichspannung, mit einer Leistungsdichte von größer oder gleich 20 W/cm² pro Puls, insbesondere größer oder gleich 50 W/cm² pro Puls, insbesondere größer oder gleich 100 W/cm² pro Puls, und/oder mit einem auf kleiner oder gleich 25 %, insbesondere auf kleiner oder gleich 10 %, verbesserten Tastverhältnis erzeugbar ist, angeschlossen.

Vorzugsweise kann an die erfindungsgemäße Gasflußsputter-Quelle mindestens eine zusätzliche Einströmvorrichtung für reaktives Gas angebracht sein, so dass die Gasflußsputter-Quelle auch für reaktives Gasflußsputtern eingesetzt werden kann.

Bei dem erfindungsgemäßen Gasflußsputterverfahren wird an die Hohlkathode einer beliebigen Gasflußsputter-Quelle eine gepulste Spannung mit einem Tastverhältnis (engl. "Duty cycle") von kleiner oder gleich 50 % angelegt. Es hat sich herausgestellt, dass durch eine derartig gepulste Spannung im Inneren der Hohlkathode nicht nur Gasionen mit erhöhter Energie, sondern auch Targetionen mit hoher Energie und hohem Ionisationsgrad erzeugt werden, so dass auf das Anlegen einer Biasspannung, wie im Stand der Technik erforderlich, verzichtet werden kann.

Beim Verfahren der vorliegenden Erfindung ist der Ionisationsgrad der Targetatome im Unterschied zum Stand der Technik deutlich größer, so dass ein erheblicher Teil der Targetatome in ionisierter Form und damit mit höherer Energie als die neutralen Targetatome das Substrat erreicht und dort über eine größere Oberflächenbeweglichkeit verfügt und dadurch kompaktere Schichten bilden kann.

Um die Energie der Targetionen noch weiter zu erhöhen, können Spannungspulse mit Leistungsdichten von 20 W/cm² oder mehr, insbesondere 50 W/cm² pro Puls oder mehr, insbesondere 100 W/cm² pro Puls oder mehr, mit Spitzenleistungen im Bereich von 100 kW bis 50 MW, insbesondere im Bereich von einigen 100 kW bis einigen MW, insbesondere im Bereich von 200 kW bis 3 MW, und/oder mit einem Tastverhältnis (engl. "Duty cycle") von 50 % oder weniger, insbesondere von 25 % oder weniger, insbesondere von 10 % oder weniger, angelegt werden.

Der Kern der Erfindung besteht also darin, dass durch den Einsatz einer speziell gepulsten Spannungsquelle, also durch das Anlegen einer bestimmten gepulsten Spannung an die Hohlkathode, nicht nur energiereiche Gasionen erzeugt werden, sondern auch energiereiche Targetteilchen. Die Schichten werden damit nicht nur durch Neutralteilchen, sondern durch Ionen gebildet, wodurch die Struktur der aufwachsenden Schichten beeinflussbar ist. Im Gegensatz zu herkömmlichen Verfahren, mit denen Targetteilchen mit einer Energie von kleiner als 0.5 eV erzeugt werden, können mit der erfindungsgemäßen Gasflußsputter-Quelle bzw. mit dem erfindungsgemäßen Gasflußsputterverfahren Targetionen mit Energien im Bereich von 0.5 bis 5eV, insbesondere im Bereich von 1 bis 3 eV, erzeugt werden. Somit treffen auch ohne zusätzliche elektrische (Biasspannung) oder magnetische Felder oder mit Feldern mit verminderter Feldstärke energiereiche Targetteilchen auf das Substrat auf, so dass Schichten mit besonderen Anforderungen, beispielsweise besonders harte Schichten, erzeugt werden können. Da durch die vorliegende Erfindung auf eine Biasspannung am Substrat verzichtet werden kann, können auch auf isolierende Substrate problemlos unterschiedliche Schichten abgeschieden werden.

Die im erfindungsgemäßen Gasflußsputterverfahren erzeugten, energiereichen Targetionen ermöglichen die Abscheidung von isolierenden Schichten mit Dicken im Bereich von 0.1 µm bis 300 µm, insbesondere im Bereich von 1 µm bis 50 µm, während mittels herkömmlichem Gasflußsputtern ohne Biasspannung nur Dicken bis zu 5 µm erreicht werden können. Auch die Dichte und Härte der mittels gepulstem Gasflußsputtern abgeschiedenen isolierenden Schichten und/oder leitenden Schichten sind gegenüber herkömmlichen Verfahren erhöht. So weist eine mit einem aus dem Stand der Technik bekannten Verfahren abgeschiedene Al₂O₃-Schicht eine Dichte von 3.4 g/cm³ und eine Härte von 12 GPa auf, während im Gegensatz dazu mit dem erfindungsgemäßen Verfahren beispielsweise Al₂O₃-Schichten mit einer Dichte von 3.8 g/cm³ und einer Härte von 20 GPa abgeschieden werden können. Ein weiterer Vorteil des erfindungsgemäßen Verfahrens liegt darin, dass die energiereichen Targetteilchen die Struktur und Morphologie nachhaltig verändern. So haben mit herkömmlichen Verfahren erzeugte Targetteilchen eine Säulenstruktur, während die nach dem erfindungsgemäßen Verfahren erzeugten Targetteilchen eine kompakte und isotrope, mikrokristalline Struktur aufweisen.

Vorzugsweise kann neben dem Inertgas auch reaktives Gas in die Hohlkathode eingeleitet werden, wie es aus diversen bekannten reaktiven Sputterverfahren bekannt ist. In herkömmlichen Gasflußsputterverfahren kann es dabei zu einer Targetvergiftung kommen. Nach dem Stand der Technik können selbst unter Einsatz einer Biasspannung auch bei leitfähiger/m Schicht/Substrat keine dicken, insbesondere mit einer Dicke größer oder gleich 10 µm, und gleichzeitig kompakten, gut isolierenden Schichten abgeschieden werden, da die Argonionen so hohe Schichtspannungen erzeugen, dass die Schichten abplatzen.

Diese Phänomene werden bei der vorliegenden Erfindung durch die Präsenz der energiereichen Targetteilchen weitgehend unterdrückt.

Mit Hilfe des erfindungsgemäßen Gasflußsputterverfahrens können die unterschiedlichsten Schichten abgeschieden werden. Insbesondere können dielektrische Schichten, Oxidschichten, tribologische Schichten und/oder sensorische Schichten hergestellt werden. Zur Erzeugung dielektrischer Schichten wird bevorzugt Blei-Zirkonat-Titanat (PZT) und/oder CuAlO₂ und/oder AgAlO₂ abgeschieden. Als Oxidschichten werden bevorzugt Schichten aus TiOₓ, Al₂O₃, teil- oder vollstabilisiertes ZrO₂, ZnO, Indium-Zinn-Oxid und/oder SiOₓ erzeugt. Unter tribologischen Schichten werden insbesondere Schichten aus den Materialien a-C und/oder a-C:H und/oder a-C:Me und/oder CrNₓ und/oder TiN und/oder ZrN und/oder TiB₂ verstanden, während zu sensorischen Schichten insbesondere magnetische und/oder piezoelektrische und/oder piezoresistive und/oder thermoelektrische und/oder thermoresistive Schichten gezählt werden. Weitere bevorzugte Schichten sind NiCr und MAX-Phasen. Unter MAX-Phasen werden nach M.W. Barsoum und T. El-Raghy (American Scientists, Vol 89 (2001), S. 334) Verbindungen mit der Zusammensetzung Mₙ₊₁AXₙ verstanden, wobei n die Werte 1, 2, oder 3 annimmt, M ein Übergangsmetall niedriger Gruppenzahl, d.h. ein Metall, das links vom Zentrum des Periodensystems steht, ist, A für ein Element aus der Elementgruppe A, d.h. ein Element, was üblicherweise in der Gruppe IIIA oder IVA des Periodensystems erscheint, steht und X entweder Kohlenstoff oder Stickstoff ist.

Im Folgenden werden zwei konkrete Anwendungsbeispiele des erfindungsgemäßen Gasflußsputterverfahrens gegeben: Im Anwendungsbeispiel 1 wird die Abscheidung von PZT auf eine Siliziumscheibe erläutert. Anwendungsbeispiel 2 beschreibt ein mit Aluminiumoxid beschichtetes Maschinenteil aus Stahl.

### Anwendungsbeispiel 1

An eine PVD-Beschichtungsanlage, die mit einer rohrförmigen GFS-Quelle ausgerüstet ist, wird ein Hochleistungspulsgenerator angeschlossen. Dabei wird der negative Ausgang mit der Hohlkathode der GFS-Quelle verbunden und der positive Ausgang mit dem Massepotential.

Die GFS-Quelle ist mit einem Sputtertarget in Hohlkathodenform bestückt, welches aus Teilen zusammengesetzt ist, die aus reinem Blei, Zirkonium und Titan bestehen. Die Vakuumkammer wird mit einer Silizium-Scheibe beschickt, die auf einem heizbaren Substrathalter montiert ist.

Die Vakuumkammer wird mittels einer Wälzkolbenpumpe evakuiert. Anschließend wird ein Argon-Gasstrom von 1 slm (Standard-Liter pro Minute) eingestellt, der durch die GFS-Quelle in die Vakuumkammer strömt, so dass sich in der Vakuumkammer ein Druck von 0.5 mbar einstellt.

Die Silizium-Scheibe wird auf 600 °C geheizt. Danach wird eine gepulste Gleichspannung von etwa -150 V an die Silizium-Scheibe angelegt, wodurch sich eine Glimmentladung ausbildet, die störende Oberflächenbeläge von der Silizium-Scheibe entfernt.

Gleichzeitig wird die GFS-Quelle durch Betrieb mit einer geringen Leistung von etwa 200 W von Oxidbelägen der Sputtertargets gereinigt. In dieser Phase ist die Öffnung der GFS-Quelle durch eine Blende weitgehend verschlossen.

Nach Abschluss dieser Vorbereitungen wird die Silizium-Scheibe vor die GFS-Quelle bewegt, die Quellenleistung am Hochleistungspulsgenerator auf 1 kW eingestellt, reiner Sauerstoff mit einem Massenfluss von 0,01 slm in die Kammer geleitet, die Substratvorspannung auf -80 V eingestellt und die Blende von der Quellenöffnung entfernt. Dadurch kommt es zur Abscheidung einer kristallinen, piezoelektrischen Schicht aus Blei-Zirkonat-Titanat auf der Silizium-Scheibe.

Nach Erreichen einer Schichtdicke von 10 µm wird die Quellenöffnung verschlossen, die GFS-Quelle, die Prozessgase und die Substratheizung abgestellt. Nach Abkühlung auf 80 °C wird die Vakuumkammer belüftet und die Silizium-Scheibe entnommen.

### Anwendungsbeispiel 2

An eine PVD-Beschichtungsanlage, die mit einer linearen GFS-Quelle ausgerüstet ist, wird ein Hochleistungspulsgenerator angeschlossen. Dabei wird der negative Ausgang mit der Hohlkathode der GFS-Quelle verbunden und der positive Ausgang mit dem Massepotential.

Die GFS-Quelle ist mit zwei rechteckigen Sputtertargets aus reinem Aluminium bestückt, die eine Hohlkathode bilden.

Die Vakuumkammer wird mit einem Maschinenteil bestückt, welches aus Stahl besteht und mit einem Dünnschicht-Sensor versehen werden soll.

Die Vakuumkammer wird mittels einer Wälzkolbenpumpe evakuiert. Anschließend wird ein Argon-Gasstrom von 3 slm (Standard-Liter pro Minute) eingestellt, der durch die GFS-Quelle in die Vakuumkammer strömt.

Das Maschinenteil wird auf 150 °C geheizt. Danach wird eine gepulste Gleichspannung von etwa -150 V an das Maschinenteil angelegt, wodurch sich eine Glimmentladung ausbildet, die störende Oberflächenbeläge von der Oberfläche des Maschinenteils entfernt.

Gleichzeitig wird die GFS-Quelle durch Betrieb bei geringer Leistung von Oxidbelägen der Sputtertargets gereinigt. In dieser Phase ist die Öffnung der GFS-Quelle durch eine Blende weitgehend verschlossen.

Nach Abschluss dieser Vorbereitungen wird das Maschinenteil vor die GFS-Quelle bewegt, die Quellenleistung am Hochleistungspulsgenerator auf 3 kW eingestellt, reiner Sauerstoff mit einem Massenfluss von 0,04 slm in die Kammer geleitet, die Substratvorspannung auf -100 V eingestellt und die Blende von der Quellenöffnung entfernt. Dadurch kommt es zur Abscheidung einer mikrokristallinen, elektrisch hoch isolierenden Schicht aus Aluminiumoxid auf dem Maschinenteil.

Nach Erreichen einer Schichtdicke von 2 µm wird die Quellenöffnung verschlossen und die GFS-Quelle und die Prozessgase abgestellt. Anschließend wird das Maschinenteil vor eine weitere GFS-Quelle bewegt, mit welcher dann eine Sensorschicht auf der Oberseite der Aluminiumoxidschicht abgeschieden wird.

## Patentansprüche

1. Gasflußsputter-Quelle mit einer Hohlkathode und einer Anode, wobei an einer ersten Seite der Hohlkathode mindestens eine Einströmvorrichtung für Inertgas angebracht ist und an einer zweiten Seite der Hohlkathode eine Öffnung zum Überführen von zerstäubtem Kathodenmaterial auf ein Substrat gegeben ist, wobei zwischen der Anode und der Hohlkathode ein Hochleistungspulsgenerator angeschlossen ist, mit dem eine gepulste Spannung erzeugbar ist, **dadurch gekennzeichnet, dass** die Quelle ein Tastverhältnis zwischen der Dauer eines Pulses zur Erzeugung von Targetionen mit hoher Energie und hohem Ionisationsgrad und der Periodendauer von kleiner oder gleich 50 % aufweist.

2. Gasflußsputter-Quelle nach dem vorhergehenden Anspruch, **dadurch gekennzeichnet, dass** mit dem Hochleistungspulsgenerator eine gepulste Spannung mit einer hohen gemittelten Leistungsdichte auf der Kathodenoberfläche, vorteilhafterweise größer oder gleich 20 W/cm² pro Puls, insbesondere größer oder gleich 50 W/cm² pro Puls, insbesondere größer oder gleich 100 W/cm² pro Puls, erzeugbar ist.

3. Gasflußsputter-Quelle nach einem der vorhergehenden Ansprüche, **dadurch gekennzeichnet, dass** mit dem Hochleistungspulsgenerator eine gepulste Spannung mit hohen Spitzenleistungen im Puls, vorteilhafterweise im Bereich von 100 kW bis 50MW, insbesondere im Bereich von einigen 100 kW bis einigen MW, erzeugbar ist.

4. Gasflußsputter-Quelle nach einem der vorhergehenden Ansprüche, **dadurch gekennzeichnet, dass** mit dem Hochleistungspulsgenerator Pulse mit einem Tastverhältnis zwischen der Dauer eines Pulses und der Periodendauer kleiner oder gleich 25 %, insbesondere kleiner oder gleich 10 %, erzeugbar sind.

5. Gasflußsputter-Quelle nach einem der vorhergehenden Ansprüche, **dadurch gekennzeichnet, dass** die Gasflußsputter-Quelle zusätzlich zu der mindestens einen Einströmvorrichtung für Inertgas mindestens eine Einströmvorrichtung für reaktives Gas aufweist.

6. Gasflußsputterverfahren unter Verwendung einer Gasflußsputter-Quelle nach einem der Ansprüche 1 bis 4 zur Beschichtung von Substraten mittels Gasflußsputtern mit einer Hohlkathodenentladung in einem Inertgasstrom, wobei die Hohlkathodenentladung im Inneren der Hohlkathode durch eine gepulste Spannung angeregt wird, **dadurch gekennzeichnet, dass** die Quelle ein Tastverhältnis zwischen der Dauer eines Pulses zur Erzeugung von Targetionen mit hoher Energie und hohem Ionisationsgrad und der Periodendauer von kleiner oder gleich 50 % aufweist.

7. Gasflußsputterverfahren zur Beschichtung von Substraten nach dem vorhergehenden Anspruch, **dadurch gekennzeichnet, dass** die Hohlkathodenentladung durch eine gepulste Spannung mit einer hohen gemittelten Leistungsdichte auf der Kathodenoberfläche, vorteilhafterweise größer oder gleich 20 W/cm², insbesondere größer oder gleich 50 W/cm² pro Puls, insbesondere größer oder gleich 100 W/cm² pro Puls, angeregt wird.

8. Gasflußsputterverfahren zur Beschichtung von Substraten nach einem der Ansprüche 6 und 7, **dadurch gekennzeichnet, dass** die Hohlkathodenentladung durch eine gepulste Spannung mit hohen Leistungsspitzen im Puls, vorteilhafterweise im Bereich von 100 kW bis 50MW, insbesondere im Bereich von einigen 100 kW bis einigen MW, angeregt wird.

9. Gasflußsputterverfahren zur Beschichtung von Substraten nach einem der Ansprüche 6 bis 8, **dadurch gekennzeichnet, dass** die Hohlkathodenentladung durch eine gepulste Spannung mit einem Tastverhältnis zwischen der Dauer eines Pulses und der Periodendauer von kleiner oder gleich 25 %, insbesondere kleiner oder gleich 10 %, angeregt wird.

10. Gasflußsputterverfahren zur Beschichtung von Substraten nach einem der Ansprüche 6 bis 9, **dadurch gekennzeichnet, dass** das Substrat elektrisch isolierendes oder elektrisch leitendes Material enthält oder daraus besteht.

11. Gasflußsputterverfahren zur Beschichtung von Substraten nach einem der Ansprüche 6 bis 11, **dadurch gekennzeichnet, dass** neben Inertgas auch reaktives Gas in das Innere der Hohlkathode eingeleitet wird.

12. Gasflußsputterverfahren zur Beschichtung von Substraten nach einem der Ansprüche 6 bis 12, **dadurch gekennzeichnet, dass** auf das Substrat mindestens eine Schicht aufgebracht wird ausgewählt aus der Gruppe von Schichten enthaltend dielektrische Schichten, insbesondere PZT (Blei-Zirkonat-Titanat) und/oder CuAlO₂ und/oder AgAlO₂, Oxidschichten, insbesondere TiOₓ, Al₂O₃, teil- oder vollstabilisiertes ZrO₂, ZnO, Indium-Zinn-Oxid und/oder SiOₓ, tribologische Schichten, insbesondere a-C und/oder a-C:H und/oder a-C:Me und/oder CrNₓ und/oder TiN und/oder ZrN und/oder TiB₂, und sensorische Schichten, insbesondere magnetische und/oder piezoelektrische und/oder piezoresistive und/oder thermoelektrische und/oder thermoresistive Schichten, sowie NiCr und MAX-Phasen.

## Claims

1. Gas flow sputter source having a hollow cathode and an anode, wherein at least one inflow device for inert gas is attached to a first side of the hollow cathode and an opening for the transfer of sputtered cathode material to a substrate is present on a second side of the hollow cathode, wherein a high power pulse generator is connected between the anode and the hollow cathode, with which a pulsed voltage is able to be generated,
**characterised in that**
the source has a duty cycle between the duration of a pulse for generating target ions having high energy and a high degree of ionisation and the period duration of less than or equal to 50%.

2. Gas flow sputter source according to the preceding claim, **characterised in that** a pulsed voltage having a high averaged power density on the cathode surface, advantageously greater than or equal to 20W/cm² per pulse, in particular greater than or equal to 50W/cm² per pulse, in particular greater than or equal to 100W/cm² per pulse, is able to be generated with the high power pulse generator.

3. Gas flow sputter source according to one of the preceding claims, **characterised in that** a pulsed voltage having high peak powers in the pulse, advantageously in the range from 100kW to 50MW, in particular in the range from a few 100kW to a few MW, is able to be generated with the high power pulse generator.

4. Gas flow sputter source according to one of the preceding claims, **characterised in that** pulses having a duty cycle between the duration of a pulse and the period duration of less than or equal to 25%, in particular less than or equal to 10%, are able to be generated with the high power pulse generator.

5. Gas flow sputter source according to one of the preceding claims, **characterised in that**, in addition to the at least one inflow device for inert gas, the gas flow sputter source has at least one inflow device for reactive gas.

6. Gas flow sputter method using a gas flow sputter source according to one of claims 1 to 4 for coating substrates by means of gas flow sputtering with hollow cathode discharge in an inert gas flow, wherein hollow cathode discharge in the interior of the hollow cathode is induced by a pulsed voltage, **characterised in that** the source has a duty cycle between the duration of a pulse for generating target ions having high energy and a high degree of ionisation and the period duration of less than or equal to 50%.

7. Gas flow sputter method for coating substrates according to the preceding claim, **characterised in that** hollow cathode discharge is induced by a pulsed voltage having a high averaged power density on the cathode surface, advantageously greater than or equal to 20W/cm², in particular greater than or equal to 50W/cm² per pulse, in particular greater than or equal to 100W/cm² per pulse.

8. Gas flow sputter method for coating substrates according to one of claims 6 and 7, **characterised in that** hollow cathode discharge is induced by a pulsed voltage having high peak powers in the pulse, advantageously in the range from 100kW to 50MW, in particular in the range from a few 100kW to a few MW.

9. Gas flow sputter method for coating substrates according to one of claims 6 to 8, **characterised in that** hollow cathode discharge is induced by a pulsed voltage having a duty cycle between the duration of a pulse and the period duration of less than or equal to 25%, in particular less than or equal to 10%.

10. Gas flow sputter method for coating substrates according to one of claims 6 to 9, **characterised in that** the substrate contains or consists of electrically insulating or electrically conductive material.

11. Gas flow sputter method for coating substrates according to one of claims 6 to 11, **characterised in that**, in addition to inert gas, reactive gas is also introduced into the interior of the hollow cathode.

12. Gas flow sputter method for coating substrates according to one of claims 6 to 12, **characterised in that** at least one layer is applied to the substrate, selected from the group of layers containing dielectric layers, in particular PZT (lead zirconium titanate) and/or CuAlO₂ and/or AgAlO₂, oxide layers, in particular TiOₓ, Al₂O₃, partially or fully stabilised ZrO₂, ZnO, indium tin oxide and/or SiOₓ, tribological layers, in particular a-C and/or a-C:H and/or a-C:Me and/or CrNₓ and/or TiN and/or ZrN and/or TiB₂, and sensory layers, in particular magnetic and/or piezoelectric and/or piezoresistive and/or thermoelectric and/or thermoresistive layers, as well as NiCr and MAX phases.

## Revendications

1. Source de pulvérisation cathodique à flux gazeux, comprenant une cathode creuse et une anode, au moins un dispositif de pénétration pour un gaz inerte étant rapporté contre un premier côté de la cathode creuse, et une ouverture destinée à transférer le matériau de cathode pulvérisé sur un substrat étant prévue sur un deuxième côté de la cathode creuse,
un générateur d'impulsions haute puissance, à l'aide duquel il est possible de produire une tension pulsée, étant raccordé entre l'anode et la cathode creuse, **caractérisée en ce que** le rapport cyclique entre la durée d'une impulsion destinée à la production d'ions cibles avec une grande énergie et un degré élevé d'ionisation, et la durée d'une période, inférieur ou égal à 50 %.

2. Source de pulvérisation cathodique à flux gazeux selon la revendication précédente, **caractérisée en ce qu'**il est possible de produire avec le générateur d'impulsions haute puissance une tension pulsée ayant une densité de puissance moyennée élevée sur la surface cathodique, avantageusement supérieure ou égale à 20 W/cm² par impulsion, en particulier supérieure ou égale à 50 W/cm² par impulsion, en particulier supérieure ou égale à 100 W/cm² par impulsion.

3. Source de pulvérisation cathodique à flux gazeux selon l'une des revendications précédentes, **caractérisée en ce qu'**il est possible de produire avec le générateur d'impulsions haute puissance une tension pulsée ayant des tensions de crête élevées dans l'impulsion, avantageusement comprises dans la plage de 100 kW à 50 MW, en particulier dans la plage comprise entre quelques centaines de kW et quelques MW.

4. Source de pulvérisation cathodique à flux gazeux selon l'une des revendications précédentes, **caractérisée en ce qu'**il est possible de produire avec le générateur d'impulsions à grande puissance des impulsions présentant un rapport cyclique entre la durée d'une impulsion et la durée d'une période inférieur ou égal à 25 %, en particulier inférieur ou égal à 10 %.

5. Source de pulvérisation cathodique à flux gazeux selon l'une des revendications précédentes, **caractérisée en ce que** la source de pulvérisation cathodique à flux gazeux comprend, en plus du ou des dispositifs de pénétration du gaz inerte, au moins un dispositif de pénétration pour un gaz réactif.

6. Procédé de pulvérisation cathodique à flux gazeux par utilisation d'une source de pulvérisation cathodique à flux gazeux selon l'une des revendications 1 à 4 pour revêtir des substrats par pulvérisation cathodique à flux gazeux avec une décharge à cathode creuse dans un courant de gaz inerte, la décharge à cathode creuse étant excitée, dans le volume intérieur de la cathode creuse, par une tension pulsée, **caractérisé en ce que** la source présente un rapport cyclique entre la durée d'une impulsion destinée à la production d'ions cibles à haute énergie et à grand degré d'ionisation et la durée d'une période, inférieur ou égal à 50 %.

7. Dispositif de pulvérisation cathodique à flux gazeux pour revêtir des substrats selon la revendication précédente, **caractérisé en ce que** la décharge à cathode creuse est excitée par une tension pulsée, avec une densité de puissance moyennée élevée sur la surface de la cathode, avantageusement supérieure ou égale à 20 W/cm², en particulier supérieure ou égale à 50 W/cm² par impulsion, en particulier supérieure ou égale à 100 W/cm² par impulsion.

8. Dispositif de pulvérisation cathodique à flux gazeux pour revêtir des substrats selon l'une des revendications 6 et 7, **caractérisé en ce que** la décharge à cathode creuse est excitée par une tension pulsée présentant des tensions de crête élevées dans l'impulsion, avantageusement comprise dans la plage de 100 kW à 50 MW, en particulier dans la plage de quelques centaines de kW à quelques MW.

9. Dispositif de pulvérisation cathodique à flux gazeux pour revêtir des substrats selon l'une des revendications 6 à 8, **caractérisé en ce que** la décharge à cathode creuse est excitée par une tension pulsée présentant un rapport cyclique entre la durée d'une impulsion et la durée d'une période, inférieur ou égal à 25 %, en particulier inférieur ou égal à 10 %.

10. Procédé de pulvérisation cathodique à flux gazeux pour revêtir des substrats selon l'une des revendications 6 à 9, **caractérisé en ce que** le substrat contient un matériau isolant électrique ou conducteur de l'électricité, ou en est constitué.

11. Procédé de pulvérisation cathodique à flux gazeux pour revêtir des substrats selon l'une des revendications 6 à 11, **caractérisé en ce que**, outre un gaz inerte, on injecte aussi un gaz réactif dans le volume intérieur de la cathode creuse.

12. Procédé de pulvérisation cathodique à flux gazeux pour revêtir des substrats selon l'une des revendications 6 à 12, **caractérisé en ce qu'**on applique sur le substrat au moins une couche choisie dans le groupe de couches contenant des couches diélectriques, en particulier PZT (plomb-zirconate-titanate) et/ou CuAlO₂ et/ou AgAlO₂, des couches d'oxydes, en particulier TiOₓ, Al₂O₃, ZrO₂ partiellement ou complètement stabilisé, ZnO, oxyde d'indium et d'étain et/ou SiOₓ, des couches tribologiques, en particulier a-C et/ou a-C:H et/ou a-C:Me et/ou CrNₓ et/ou TiN et/ou ZrN et/ou TiB₂, et des couches sensorielles, en particulier des couches magnétiques et/ou piézo-électriques et/ou piézo-résistives et/ou thermoélectriques et/ou thermorésistives, ainsi que des phases NiCr et MAX.
